(19) Europäisches Patentamt
European Patent Office
Office européen des brevets

(11) EP 0 547 408 B1

(12) EUROPÄISCHE PATENTSCHRIFT

(45) Veröffentlichungstag und Bekanntmachung des Hinweises auf die Patenterteilung:
18.03.1998 Patentblatt 1998/12

(51) Int Cl.⁶: **H03J 5/02**

(21) Anmeldenummer: 92120007.7

(22) Anmeldetag: 25.11.1992

(54) **Autoradio**

Car radio

Autoradio

(84) Benannte Vertragsstaaten:
**AT CH DE ES FR GB IT LI PT**

(30) Priorität: **18.12.1991 DE 4141848**

(43) Veröffentlichungstag der Anmeldung:
**23.06.1993 Patentblatt 1993/25**

(73) Patentinhaber: **Blaupunkt-Werke GmbH
D-31139 Hildesheim (DE)**

(72) Erfinder:
• **Vogt, Lothar, Dr.
W-3156 Hohenhameln (DE)**
• **Bartels, Stefan, Dr.
W-3200 Hildesheim (DE)**
• **Chahabadi, Djahanyr, Dr.
23909 Ratzeburg (DE)**

(56) Entgegenhaltungen:
US-A- 4 092 594          US-A- 4 179 662
US-A- 4 268 915          US-A- 4 947 408
US-A- 4 987 605

## Beschreibung

Gegenstand des Schutzrechtes ist ein neues Autoradio mit einer Schaltungsanordnung zur Analog-Digital-Wandlung des Zwischenfrequenzsignals.

Für ein solches Autoradio ist in der Patentanmeldung EP-A-529183, welche Stand der Technik gemäß Artikel 54(3), EPÜ, darstelt, der Vorschlag näher erläutert worden, den Taktgenerator für die Analog-Digital-Wandlung auch als Referenz-Oszillator für die Phasenregelung des Mischoszillators im Abstimmteil einzusetzen und ferner als Taktfrequenz eine Frequenz von 42,75 MHz zu wählen.

Der vorliegenden Erfindung liegt die Aufgabe zugrunde, aus dieser Taktfrequenz die für die Abstimmung auf die gewünschten Sender erforderlichen Frequenzen der Mischoszillatorschwingungen in den verschiedenen Wellenbereichen herzuleiten, wobei die hierfür erforderlichen Teiler natürliche Zahlen sind und der größte erforderliche Teiler als 16stellige Digitalzahl darstellbar sein soll. Diese Aufgabe wird durch die Merkmale des Anspruchs 1 gelöst.

In der Zeichnung ist

in Fig. 1    ein Blockschaltbild einer geeigneten Abstimmschaltung dargestellt,

in Fig. 2    eine Tabelle der einzelnen Teiler in jedem Wellenbereich wiedergegeben.

Die Abstimmschaltung für ein Autoradio umfaßt als Mischstufe 1 einen Analog-IC und als ZF-Stufe 2 einen Digital-IC. Die Mischstufe 1 besitzt einen Eingang 3 für frequenzmodulierte Sender im UKW-Bereich, der auf eine .UKW-Mischstufe 5 führt und einen Eingang 4 für amplitudenmodulierte Sender im Lang-, Mittel- und Kurzwellenbereich, der auf eine AM-Mischstufe 6 führt.

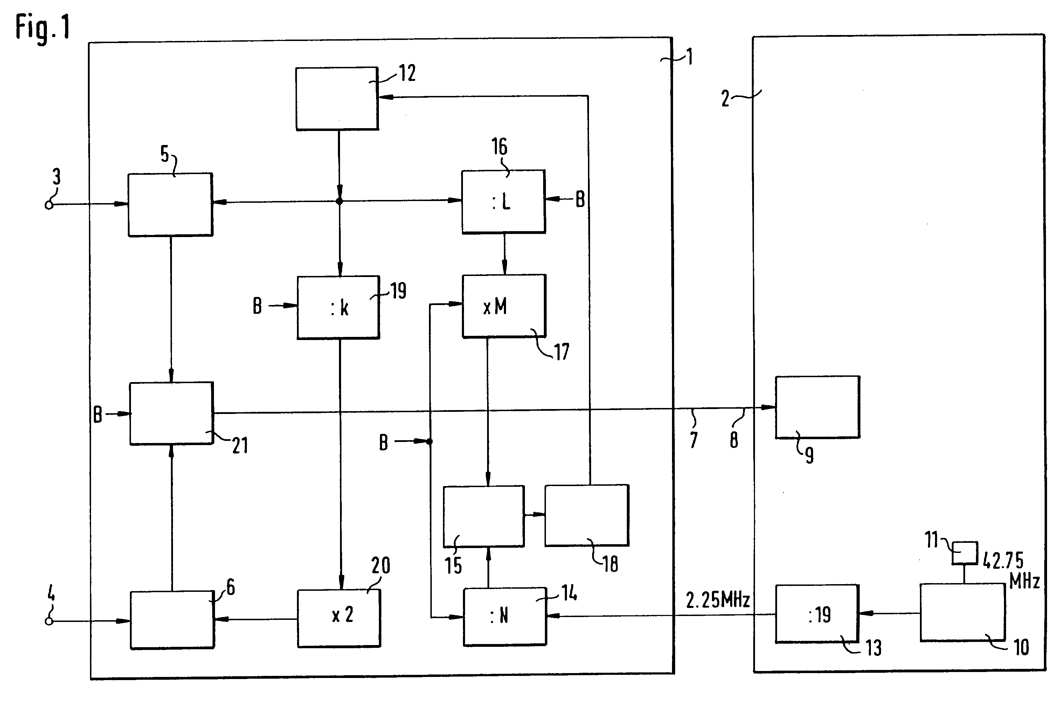

Die grundsätzliche Schaltungsstruktur der Mischstufe 1 ist aus US-A-4 268 115, insbesondere den Fig. 1, 2 und 3a bekannt. Des weiteren ist aus US-A-4 987 605, insbesondere Fig.5, eine Radioempfangseinrichtung bekannt, in welcher ein Digitaler Prozessor AM- und FM-Zwischenfrequenzsignale in digitale Signale konvertiert und weiterverarbeitet.

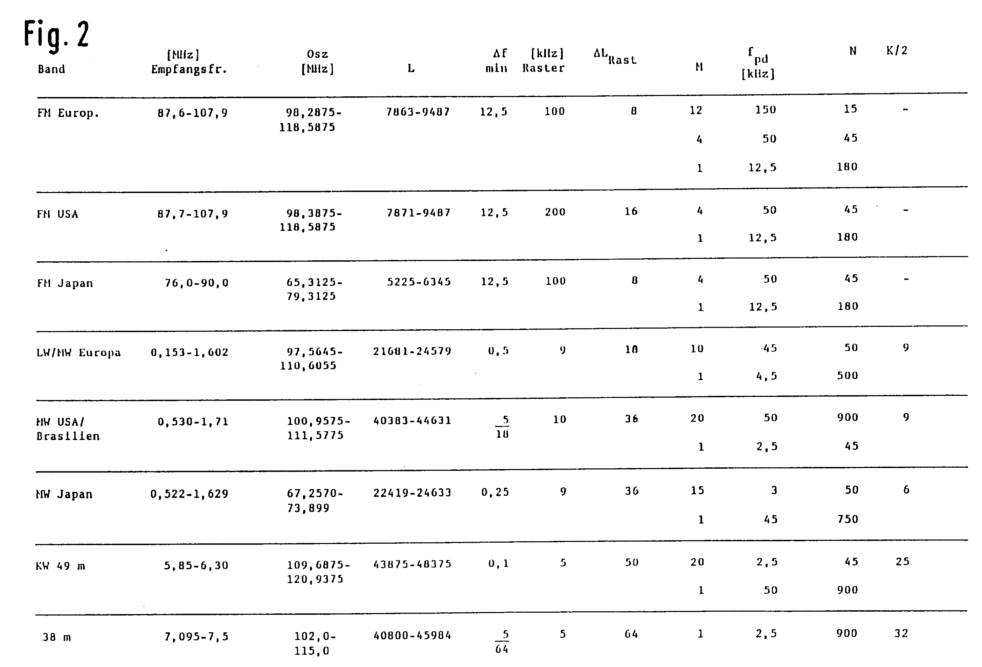

Die Sender in den genannten Empfangsbereichen liegen in Europa, USA und Japan jeweils zwischen verschiedenen Bandgrenzen. Diese sind auch der Tabelle in Fig. 2 zu entnehmen.

Der Ausgang 7 der Mischstufe 1 ist mit dem Eingang 8 eines AD-Wandlers 9 in der ZF-Stufe 2 verbunden, deren Taktgenerator 10 in ihrer Frequenz von dem Quarz 11 gehalten wird. Die Innenschaltung der ZF-Stufe 2 ist hier nicht weiter relevant und daher auch nicht dargestellt. Der Taktgenerator 10 ist, wie in der älteren Anmeldung beschrieben, der Referenzoszillator für den variablen Mischoszillator 12 in der Mischstufe 1 1. Die Taktfrequenz wird noch innerhalb des der ZF-Stufe 2 durch den Teiler 19 geteilt, so daß am Ausgang der Teilerstufe 13 eine Rechteckschwingung der Frequenz 2,25 MHz abgreifbar ist.

Innerhalb der Mischstufe 1 wird diese Frequenz erneut in der Teilerstufe 14 geteilt, und zwar durch einen Teiler N. Die Größe dieses Teilers ist einerseits vom Wellenbereich, der empfangen werden soll, abhängig, andererseits auch von der Arbeitsfrequenz des Phasendiskriminators 15, mit dem der Ausgang der Teilerstufe 14 verbunden ist.

In dem Phasendiskriminator 15 wird die an der Teilerstufe 14 abgenommene Frequenz verglichen mit einer Frequenz, die aus der Frequenz des Mischoszillators 12 hergeleitet ist, und zwar in dem diese in der Teilerstufe 16 durch einen Teiler L geteilt worden ist. Die Größe des Teilers L hängt von der Frequenzlage des Senders innerhalb des Wellenbereiches ab, der gerade eingestellt ist.

In dem Ausführungsbeispiel wird die am Ausgang der Teilerstufe 16 anliegende Frequenz anschließend in einer Multiplizierstufe 17 mit einem Faktor M multipliziert. Der Faktor M bestimmt die Arbeitsfrequenz des Phasendiskriminators mit. Der Faktor M und der Teiler N sind voneinander abhängig; wird M größer gewählt, ist N entsprechend zu verkleinern.

Im Ausgang des Phasendiskriminators 15 liegt ein Schleifenfilter 18, dessen niederfrequentes Ausgangssignal den Mischoszillator 12 bei einer Frequenzabweichung von der Sollage oder bei einem Wechsel des Senders nachführt.

Die Frequenz des Mischoszillators 12 wird einerseits in der UKW-Mischstufe 5 direkt mit dem Eingangssignal am Signaleingang 3 gemischt, während zur Mischung mit dem AM-Eingangssignal am Signaleingang 5 in der AM-Mischstufe 6 die Oszillatorfrequenz in der Teilerstufe 19 zunächst durch einen Teiler K geteilt wird, dessen Wert wiederum von dem Frequenzband abhängt, in dem der zu empfangende Sender liegt. Die Umschaltung der Empfangsbereiche erfolgt bei den abhängigen Stufen jeweils über den Steuereingang B. In dem Ausführungsbeispiel in Fig. 1 wird das heruntergeteilte Oszillatorsignal in eine Multiplizierstufe 20 mit "zwei" multipliziert. Dadurch wird sichergestellt, daß in der AM-Mischstufe 6 keine unsymmetrischen Störfrequenzen auftreten.

Die Ausgänge beider Mischstufen sind mit einem Umschalter 21 verbunden, dessen Stellung ebenfalls vom Wellenbereichsschalter gesteuert wird. Der Ausgang des Umschalters 21 ist mit dem Ausgang 7 der Mischstufe 1 direkt verbunden.

Der Tabelle in Fig. 2 liegt zugrunde, daß die Trägerfrequenzen der einzelnen Sender in den einzelnen Empfangsbereichen einen genormten Abstand von der benachbarten Trägerfrequenz einhalten, also in einem vorgegebenen Raster liegen müssen.

Im UKW-Bereich beträgt dieser Frequenzrasterabstand $f_{min}$ = 100 kHz. Um das Radio von einem Sender auf den nächsten Sender abzustimmen, muß daher die Frequenz des Mischoszillators um mindestens 100 kHz erhöht oder erniedrigt werden. Diese veränderte Frequenz muß nach der Teilung L wieder die Arbeitsfrequenz des Phasendiskriminators ergeben. Zugleich muß L sich bei jedem neuen Sender als natürliche Zahl darstellen lassen. Schließlich soll die größte erforderliche Teilzahl L sich noch als eine 16stellige Binärzahl darstellen lassen. Diese Voraussetzungen führen zu den in der Tabelle angegebenen Zahlenwerten.

Daraus folgt, daß

$$\frac{f_{osz,n}}{L} = \frac{f_{osz,\,n+1}}{L+1} = \text{const.}$$

ist.

Es hat sich gezeigt, daß diese Frequenzdifferenz kleiner sein muß als das Frequenzraster, wenn man mit natürlichen Zahlen des Teilers arbeiten will. Um von einem eingestellten Sender zu dem benachbarten Sender überzugehen, muß daher L jeweils um mehrere Einheiten erhöht werden, deren Zahl jedoch innerhalb eines Frequenzbandes gleichbleibt.

Die Arbeitsfrequenz der Phasenregelschleife ist im Ausführungsbeispiel mittels der Multiplizierstufe M auf verschiedene Werte einstellbar. Bei dem Empfang eines Senders bzw. bei der Einstellung der benachbarten Sender nacheinander ist eine geringe Arbeitsfrequenz des Phasendiskriminators von Vorteil. Ist es hingegen zur Einstellung eines neuen Senders erforderlich, einen großen Frequenzbereich zu überspringen, dann ist eine höhere Arbeitsfrequenz des Phasendiskriminators günstig.

Je nach der Wahl der Arbeitsfrequenz muß auch der Teiler N gewählt werden, mit dem die Referenzfrequenz erniedrigt wird. Auf der Seite des Oszillators wird der Faktor M im Multiplizierer bei einer Änderung der Arbeitsfrequenz umgeschaltet. Auch der Faktor M soll stets eine natürliche, d. h. ganze Zahl, sein. Die Variationsmöglichkeiten für M und N sind ebenfalls in der Tabelle 2 dargestellt.

Die Bedingung, daß L stets ganzzahlig sei und auch mit 16 Bit darstellbar bleiben soll, führt dazu, daß der Mischoszillator 12 im Bereich der amplitudenmodulierten Träger auf eine Frequenz eingeregelt werden muß, die sich nicht unmittelbar als Mischfrequenz eignet. Daher wird bei der Wahl der verschiedenen AM-Empfangsbänder die Oszillatorfrequenz durch verschiedene Werte für K geteilt.

Der Phasendiskriminator 15 umfaßt, wie aus dem Blockschaltbild hervorgeht, ein einziges Schleifenfilter 18. Wenn man für die Arbeitsfrequenz des Phasendiskriminators 50 kHz wählt, dann kann man diese Arbeitsfrequenz in allen Wellenbereichen beibehalten. Bei einer anderen Wahl der Arbeitsfrequenz müssen mindestens zwei Schleifenfilter vorgesehen sein, eine für den UKW-Bereich und eine für die AM-Wellenbereiche, da der Stabilitätsbereich der PLL bei konstantem Schleifenfilter relativ schmalbandig ist.

Aus der Tabelle in Figur 2 läßt sich entnehmen, daß sich im UKW-Bereich bei Erhöhung des Teilers L um eine Einheit die Oszillatorfrequenz um 12,5 kHz erniedrigt. Bei den AM-Empfangsbereichen sind die Änderungen der Oszillatorfrequenzen entsprechend geringer.

Wird in dem UKW-Bereich M = 1 gewählt, dann ist damit die Arbeitsfrequenz des Phasendiskriminators auf 12,5 kHz gelegt. Wird eine höhere Arbeitsfrequenz gewünscht, dann ist der Multiplikator M größer 1 zu wählen; dementsprechend ist der Teiler N herabzusetzen.

Die Vorgabe für die Zahlengröße des Teilers ergibt eine untere Frequenzgrenze des Mischoszillators, die für die Mischung in den AM-Bereichen zu groß ist. Daher ist in diesen Empfangsbereichen eine zusätzliche Teilung der Frequenzen des Mischoszillators mit dem Teiler K erforderlich.

## Patentansprüche

1. Autoradio mit einer Schaltung zur Analog-Digital-Wandlung des Zwischenfrequenzsignals (7,8), bei dem der Mischoszillator in der Mischstufe (1) in seiner Phase geregelt ist und der Referenzoszillator für die Phasenregelung der Taktgenerator des Analog-Digital-Wandlers (9) in der ZF-Stufe (2) ist, wobei

   dem Taktgenerator (10) eine erste Teilerstufe (13, 14) mit einem bei der Bandumschaltung schaltbaren Teilerverhältnis (N) nachgeschaltet ist und diese Teilerstufe mit einem Eingang eines Phasendiskriminators (15) verbunden ist, daß dem Ausgang des Mischoszillators (12) eine zweite Teilerstufe (16, 17) mit einem zur Abstimmung des Autoradios auf den Sender dienenden variablen Teilerverhältnisses (L; L x M) nachgeschaltet ist und daß dessen Ausgang mit dem zweiten Eingang des Phasendiskriminators (15) verbunden ist, daß der Ausgang des Mischozillators (12) ferner einerseits mit einer UKW-Mischstufe (5) direkt verbunden ist und andererseits über eine bei der Bandumschaltung in ihrem Teilerverhältnis (K) umschaltbaren dritten Teilerstufe (19, 20) an den Eingang einer AM-Mischstufe (6) angeschlossen ist, wobei die Teilerverhältnisse so gewählt sind, daß alle Teiler in allen Empfangsbändern natürliche Zahlen sind und daß die Ausgänge beider Mischstufen (4, 6) über einen Bandumschalter (21) wahlweise mit dem Eingang (8) des Analog-Digital-Wandlers (9) in der ZF-Stufe (2) des Autoradios verbindbar sind.

2. Autoradio nach Anspruch 1, dadurch gekennzeichnet, daß die Taktfrequenz des Taktgenerators 42,75 MHz beträgt und die Teiler K, L, N sowie der Multiplikator M die in der Tabelle Fig. 2 aufgeführten Werte haben.

## Claims

1. Car radio having a circuit for analogue/digital conversion of the intermediate frequency signal (7, 8), in which the phase of the mixing oscillator in the mixer stage (1) is controlled, and the reference oscillator for phase control is the clock generator of the analogue/digital converter (9) in the IF stage (2),

   the clock generator (10) having connected downstream of it a first divider stage (13, 14) with a division ratio (N) which can be switched in the event of band changing, and this divider stage being connected to the input of a phase discriminator (15),
   the output of the mixing oscillator (12) having connected downstream of it a second divider stage (16, 17) with a variable division ratio (L; L x M) which is used to tune the car radio to the transmitter, its output being connected to the second input of the phase discriminator (15),
   the output of the mixing oscillator (12) furthermore being directly connected on the one hand to a VHF mixer stage (5) and, on the other hand, being connected to the input of an AM mixer stage (6) via a third divider stage (19, 20) whose division ratio (K) can be changed for band changing, the division ratios being selected such that all the divisors in all the reception bands are natural numbers,
   and it optionally being possible to connect the outputs of the two mixer stages (4, 6) via a band changeover switch (21) to the input of the analogue/digital converter (9) in the IF stage (2) of the car radio.

2. Car radio according to Claim 1, characterized in that the clock frequency of the clock generator is 42.75 MHz, and the divisors K, L, N as well as the multiplication factor M have the values quoted in the table in Fig. 2.

## Revendications

1. Autoradio comprenant un circuit de conversion analogique/numérique du signal de fréquence intermédiaire (7, 8), dont l'oscillateur mélangeur est régulé en phase dans l'étage moyen (1) et l'oscillateur de référence est le générateur d'horloge du convertisseur analogique/numérique (9) de l'étage intermédiaire (2) pour la régulation de phase, selon lequel :

   • le générateur d'horloge (10) est suivi d'un premier étage diviseur (13, 14) ayant un rapport de division (N) commutable par la commutation de bande, et relié à l'entrée d'un discriminateur de phase (15),
   • la sortie de l'oscillateur mélangeur (12) est suivie d'un second étage diviseur (16, 17) à un rapport de division variable (L ; L x M) servant à accorder l'autoradio sur l'émetteur, et
   • sa sortie est reliée à la seconde entrée du discriminateur de phase (15),
   • la sortie de l'oscillateur de mélange (12) est en outre reliée directement d'un côté à un étage mélangeur FM (5) et de l'autre côté, par un troisième étage diviseur (19, 20) commutable sur son rapport de division (K) lors de la commutation de la bande, à l'entrée d'un étage mélangeur AM (6),
   • les rapports de division étant choisis pour que tous les diviseurs de toutes les bandes de réception soient des nombres naturels et que les sorties des deux étages mélangeurs (4, 6) soient reliées par un commutateur de bande (21), au choix avec l'entrée (8) du convertisseur analogique/numérique (9) de l'étage de fréquence intermédiaire FI (2) de l'autoradio.

2. Autoradio selon la revendication 1, caractérisé en ce que la fréquence d'horloge du générateur de fréquence est égale à 42,75 MHz et les diviseurs K, L, N ainsi que le multiplicateur M ont les valeurs indiquées dans le tableau de la figure 2.

EP 0 547 408 B1

Fig.1

# Fig. 2

| Band | [MHz] Empfangsfr. | Osz [MHz] | L | Δf min | [kHz] Raster | ΔL$_{Rast}$ | M | f$_{pd}$ [kHz] | N | K/2 |
|---|---|---|---|---|---|---|---|---|---|---|
| FM Europ. | 87,6-107,9 | 98,2875-118,5875 | 7863-9487 | 12,5 | 100 | 8 | 12 | 150 | 15 | - |
|  |  |  |  |  |  |  | 4 | 50 | 45 |  |
|  |  |  |  |  |  |  | 1 | 12,5 | 180 |  |
| FM USA | 87,7-107,9 | 98,3875-118,5875 | 7871-9487 | 12,5 | 200 | 16 | 4 | 50 | 45 | - |
|  |  |  |  |  |  |  | 1 | 12,5 | 180 |  |
| FM Japan | 76,0-90,0 | 65,3125-79,3125 | 5225-6345 | 12,5 | 100 | 8 | 4 | 50 | 45 | - |
|  |  |  |  |  |  |  | 1 | 12,5 | 180 |  |
| LW/MW Europa | 0,153-1,602 | 97,5645-110,6055 | 21681-24579 | 0,5 | 9 | 18 | 10 | 45 | 50 | 9 |
|  |  |  |  |  |  |  | 1 | 4,5 | 500 |  |
| MW USA/ Brasilien | 0,530-1,71 | 100,9575-111,5775 | 40383-44631 | $\frac{5}{18}$ | 10 | 36 | 20 | 50 | 900 | 9 |
|  |  |  |  |  |  |  | 1 | 2,5 | 45 |  |
| MW Japan | 0,522-1,629 | 67,2570-73,899 | 22419-24633 | 0,25 | 9 | 36 | 15 | 3 | 50 | 6 |
|  |  |  |  |  |  |  | 1 | 45 | 750 |  |
| KW 49 m | 5,85-6,30 | 109,6875-120,9375 | 43875-48375 | 0,1 | 5 | 50 | 20 | 2,5 | 45 | 25 |
|  |  |  |  |  |  |  | 1 | 50 | 900 |  |
| 38 m | 7,095-7,5 | 102,0-115,0 | 40800-45984 | $\frac{5}{64}$ | 5 | 64 | 1 | 2,5 | 900 | 32 |

EP 0 547 408 B1